(19) Europäisches Patentamt
European Patent Office
Office européen des brevets

(11) **EP 4 469 810 B1**

(12) **EUROPEAN PATENT SPECIFICATION**

(45) Date of publication and mention
of the grant of the patent:
**30.07.2025 Bulletin 2025/31**

(21) Application number: **24716798.4**

(22) Date of filing: **04.04.2024**

(51) International Patent Classification (IPC):
*G01R 15/20* (2006.01)    *G01R 19/00* (2006.01)
*G01R 19/25* (2006.01)

(52) Cooperative Patent Classification (CPC):
**G01R 15/207; G01R 19/0092; G01R 19/25**

(86) International application number:
**PCT/EP2024/059271**

(87) International publication number:
**WO 2024/209016 (10.10.2024 Gazette 2024/41)**

(54) **METHOD AND DEVICE FOR NON-INTRUSIVE CURRENT MEASUREMENT IN AN ELECTRIC CONDUCTOR**

VERFAHREN UND VORRICHTUNG ZUR NICHTINTRUSIVEN STROMMESSUNG IN EINEM MEHRLEITERKABEL

PROCÉDÉ ET DISPOSITIF DE MESURE NON INTRUSIVE DE COURANT DANS UN CÂBLE MULTICONDUCTEUR

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **04.04.2023 EP 23166603**

(43) Date of publication of application:
**04.12.2024 Bulletin 2024/49**

(73) Proprietor: **Pucki GmbH**
**22926 Ahrensburg (DE)**

(72) Inventors:
• **BOLL, Hans-Peter**
**18258 Kassow (DE)**
• **VON BRAUN, Max**
**82362 Weilheim (DE)**

(74) Representative: **Reitstötter Kinzebach**
**Patentanwälte**
**Sternwartstraße 4**
**81679 München (DE)**

(56) References cited:
WO-A1-2013/068360    WO-A1-2018/209436
DE-A1- 102018 116 616    US-A1- 2019 195 917

• **GENG GUANGCHAO ET AL: "Noninvasive Current Sensor for Multicore Cables", IEEE TRANSACTIONS ON POWER DELIVERY, IEEE SERVICE CENTER, NEW YORK, NY, US, vol. 33, no. 5, 1 October 2018 (2018-10-01), pages 2335 - 2343, XP011690580, ISSN: 0885-8977, [retrieved on 20180921], DOI: 10.1109/ TPWRD.2018.2813540**

**Description**

The present invention concerns a method and a device for non-intrusive measurements of electrical currents flowing at least one electrical conductor, especially in more than one conductor, for instance in the conductors of a multi-conductor cable, for example a hand-held device or a stationary, permanently mountable device for non-intrusive measurements of electrical current.

Conventionally, so-called ammeters, which is an abbreviation of Ampere meters, are used to measure electrical current in a circuit. Typically, ammeters are directly connected in series within the circuit in which the current is to be measured. Such a device allows for the most precise measurement of electrical current flowing in a single conductor. However, often it is not possible or not desired to integrate a measurement device directly into a circuit. Therefore, measurement devices have been developed which allow for a non-intrusive measurement of electrical currents in electrical conductors. A typical example is a so-called "*current clamp*", which is an electrical device provided with movable clamps, jaws or brackets, which can be arranged around an electrical conductor. There are various types of current clamps such as the current transformer type, where the clamp comprises a split ring made of ferrite or soft iron with a wire coil wound around one half or both halves forming one winding of a current transformer, while the electrical conductor to be measured forms the other winding. The current transformer type can be used to measure alternating current (AC). Other types, such as the iron vane type or the Hall effect type, are able to measure both, direct current (DC) and AC. Typical clamp meters are, however, limited to measuring the electrical current in a single conductor because in a multi-conductor cable external effects, such as magnetic fields induced by electrical charges within the conductors, are increasingly complicated and, more importantly, fully or partially cancel at least in the far field, so that any inference from measured magnetic fields to the electrical current flowing in the individual conductors is rather difficult. For instance, in a two-conductor cable, there is one outgoing conductor and one return conductor, which generates opposing magnetic fields, which, at some distance from the conductors, essentially cancel each other.

In order to solve this problem, several solutions have been proposed in prior art. For instance, U.S. Patent Application US 2012/0319676 A1 describes a current sensing device, which includes multiple semiconductor magnet field sensors integrated in a housing that can be detachably coupled to a multi-conductor cable, and which provides one or more outputs indicative of the currents passing through the multiple conductors in the cable. US 2012/0319676 A1 does, however, not describe how currents are determined from the output of the individual sensors. This prior art document only describes the case for a two-conductor cable in more detail, indicating that depending on the individual locations of the sensors, each sensor will couple more or less to either of the two conductors, but cautions that measurements made with this system provide merely a signature of the current in the cable but not necessarily an absolute current of a power magnitude.

International Patent Application WO2015/144541 A2 describes a similar device, namely a device for permanent, non-contact measurement of current strength in sheathed conductors, which comprises a sensor head in the form of a cuff with multiple magnetic field sensors arranged therein. This document describes that the effectively flowing currents in the individual conductors are calculated using previously empirically determined algorithms for the mathematical description of the relationship between a current in individual conductors of a conductor bundle and the magnetic fields which they generate. The system described in this document requires an adaptation of the position of the magnetic field sensors within the claw, both in terms of their circumferential position and in terms of their orientation of their plane with respect to the circumferential line of the claw.

International Patent Application WO2013/068360 A1 describes a device for measuring currents in the conductors of a sheathed cable of a poly-phase network, which uses at least three magnetic sensors arranged around a central orifice intended to be traversed by the cable to be measured, where the number of conductors is less than the number of sensors. The currents in the individual cables are determined by forming a vector [B], which includes a measurement of the magnetic field of each of the sensors and calculating a vector [I] for the currents flowing through the cable, having a given cable configuration by accessing a library of matrices [K] and [K]$^+$, where [K]$^+$ is a pseudo-inverse matrix of the matrix [K] and selecting the matrices such that a residual vector [R], calculated on the basis of [K], [K]+ and [B] for various configurations of cables and various angular positions of said sensors with respect to these cables is minimal.

The technical problem underlying the present invention resides in providing a method and an easy-to-use device, e.g. a stationary device or a handheld device, for determining the electrical current flowing in at least one electrical conductor, for instance in the conductors of a multi-conductor cable, which is more precise and more reliable than prior art methods.

This technical problem is solved by the method of present claim 1 and the device of present claim 15. Preferred embodiments of the present invention are subject of the dependent claims.

Accordingly, the present invention concerns a method for non-intrusive current measurement in at least one electrical conductor, comprising the steps of:

a) arranging one or more magnetic sensor at a number L of different locations adjacent to a number N of individual electrical conductors, said conductors extending in a third direction z;

b) performing a number M of measurements at a sampling frequency fs of a magnetic field $\vec{H}$ at least in a first direction x making a first angle with said third direction z and in a different second direction y making a second angle with said third direction z, at each of said number L of different locations, to obtain said number M of measurement data for each of said first and second directions x, y;

c) performing a harmonic analysis, preferably a discrete Fourier transformation, on each set of said number M of measurement data for each of said first and second directions x, y to obtain frequency distributions of said measurement data;

d) determining a current frequency fc of electrical currents I flowing in said conductors;

e) selecting magnetic field amplitude coefficients which correspond at least to said current frequency fc from said frequency distributions of said measurement data to obtain a first component $H_x$ of said magnetic field ( $\vec{H}$ ) in said first direction x and of a second component $H_y$ of said magnetic field $\vec{H}$ in said second direction y at each of said number L of different locations; and

f) calculating electrical currents values $I_j$ for currents flowing in each conductor from said first and second components $H_x$, $H_y$ of said magnetic field $\vec{H}$ at each of said number (L) of different locations.

A conductor extending in a certain direction does not necessarily mean that the conductor has to extend in a straight line. In case of conductors which exhibit a curved configuration, this direction refers to the tangent of the conductor at closest proximity to the one or more magnetic sensors.

The steps of the method of the present invention do not necessarily have to performed in the order indicated above. For instance, if the fundamental frequency of the current to be measured is already known in advance, step d) can be performed any time before step e).

The method of the present invention can be applied to a single electrical conductor or to an arrangement of more than conductor.

In the broadest sense, the arrangement of one or more magnetic sensors constitutes a sensor head. Preferably, however, the sensor head is a dedicated component in which the one or more magnetic sensors are arranged. In certain embodiments, the sensor head can comprise an aperture through which the at least one electrical conductor passes. The aperture has a central axis A extending in a third direction z. Consequently, the conductor passing through the aperture will also extend in the third direction z, at least in the segment passing through the aperture.

Generally, the magnetic sensors are arranged at a number L of different locations, for instance at the inner surface of the aperture of the sensor head, with said number L of different locations being larger than said number N of individual conductors. This allows current measurements to be performed without requiring prior information regarding distance of the conductors or tilting and twisting of the conductors with respect to the magnetic sensors. However, the more prior information regarding configuration of the conductors is available, the fewer magnetic sensors are required because the evaluation methods can be specifically adapted or trained to this configuration. In optimal scenarios, only one magnetic sensor can be sufficient.

In certain embodiments of the method of the present invention, the one or more conductors are arranged in a multi-conductor cable.

Consequently, the present invention also concerns a method for non-intrusive current measurement in a multi-conductor cable, comprising the steps of:

a) arranging a multi-conductor cable having a number N of individual conductors in an aperture of a sensor head, said aperture having a central axis A extending in a third direction z, said sensor head having an inner surface defining a circumference of said aperture and a multiplicity of magnetic sensors arranged at a number L of different locations at said inner surface, said number L of different locations being larger than said number N of individual conductors;

b) performing a number M of measurements at a sampling frequency fs of a magnetic field $\vec{H}$ at least in a first direction x making a first angle with said third direction z and in a different second direction y making a second angle with said third direction z, at each of said number L of different locations, to obtain said number M of measurement data for each of said first and second directions x, y;

c) performing a harmonic analysis on each of said number M of measurement data for each of said first and second directions x, y to obtain frequency distributions of said measurement data;

d) determining a current frequency fc of electrical currents I flowing in said multi-conductor cable;

e) selecting magnetic field amplitude coefficients which correspond at least to said current frequency fc from said frequency distributions of said measurement data to obtain a first component $H_x$ of said magnetic field $\vec{H}$ in said first direction x and of a second component $H_y$ of said magnetic field $\vec{H}$ in said second direction y at each of said number L of different locations; and

f) calculating electrical currents values $I_j$ for currents flowing in each conductor of said multi-conductor cable from said first and second components $H_x$, $H_y$ of said magnetic field $\vec{H}$ at each of said number L of different locations.

Like prior art cited above, the present invention implies the concept of using magnetic sensors arranged around a multi-conductor cable to detect magnetic fields generated by electrical currents flowing in the respective conductors of the cable. To this effect, the multi-conductor cable is arranged in an aperture of a sensor head, which has an inner surface defining a circumference of the aperture. A multiplicity of magnetic sensors is arranged at a number L of different locations at the inner surface of the sensor head. Typically, as the cable is an extended object, the aperture will have a central axis A, which essentially corresponds to the longitudinal axis of the cable, when arranged in the aperture. The aperture is typically arranged in a plane defined by a first direction x and a second direction y, while the central axis A extends in a third direction z.

According to the method of the present invention, the magnetic field is measured at least in the first direction x and the second direction y, which is different, specifically not parallel, to the first direction. In general, the first direction x, the second direction y and the third direction z can be considered as the basic directions of a three-dimensional coordinate system. Preferably, the first direction and the second direction lie in the plane of the aperture of the sensor head such that the first direction x makes a first angle with the third direction z, and the second direction y makes a second angle with the third direction z. An angle between the first direction x and the second direction y is non-zero and different from 180°. Preferably, the third direction z is perpendicular to the plane formed by directions x and y. In this case, the first angle and the second angle have the same magnitude but different orientations in three-dimensional space.

The number L of different locations, where magnetic sensors are arranged, depends on the type of magnetic sensors used. The number L of different locations has to be larger than the number N of individual conductors in the multi-conductor cable. For instance, if magnetic sensors are used, which can simultaneously measure components of the magnetic field in at least the x and y direction, then one magnetic sensor is arranged at each location, so that the number of magnetic sensors corresponds to the number L of different locations. If magnetic sensors are used, which can measure a magnetic field component only in one direction, then the number of magnetic sensors is twice the number L of different locations, because at each location, at least two magnetic sensors have to be employed.

As the magnetic fields generated by currents flowing in a multi-conductor cable produce a rather complicated magnetic field pattern, where magnetic field components generated by one conductor might even cancel with magnetic field components generated by another conductor and where typically additional external magnetic field components are present, the present invention does not use the magnetic field measured by the magnetic sensors directly. Rather, the method of the present invention suggests performing a harmonic analysis on the initial measurement results obtained via the magnetic sensors, for instance a linear transformation mapping the time-dependent measurement results into the frequency domain, for instance a discrete Fourier transformation. Other transformations can also be employed, for instance a Z-transform or a discrete Hartley transform. In the case of a discrete Fourier transform, a number M of measurements at a sampling frequency fs is performed in each of the first direction x and the second direction y, respectively. The discrete Fourier transformation is performed on each set of a M measurement data for each of the first and second directions x, y. The discrete Fourier transformation will result in a frequency distribution of the measurement data.

In a next step, a current frequency Fc of electrical currents flowing in the multi-conductor cable is determined. The term "current frequency" does not only refer to alternating current (AC) but comprises also direct current (DC), i.e. the current frequency can be larger or equal to zero (0). In the context of the present invention, the term "determined" usually means a determination via measurement but is also possible that current frequency is known in advance so that "determined" can also mean "selected based on prior knowledge". In certain embodiments, AC and DC components can be measured simultaneously. Then, only the magnetic field amplitude coefficients, which correspond to the determined current frequency Fc, are selected to obtain a first component $H_x$ of the magnetic field in the first direction x and a second component $H_y$ of the magnetic field in the second direction y at each of the L different locations. It should be noted that the actual measured quantity is the magnetic flux density B, which is related to the magnetic field strength H through the vacuum permeability ($H = B / \mu_0$). Finally, the electrical current values $I_J$ for the currents flowing in each conductor are calculated from the first and second components $H_X$, $H_Y$ of the magnetic field at each of the number L of different locations.

The harmonic analysis, especially the discrete Fourier transformation performed according to the method of the present invention essentially corresponds to a frequency filtering of the measured data, thus increasing the accuracy of the method of the present invention and allowing to perform the method of the present invention in a real-world environment, where different sources of magnetic fields interfere with each other.

The calculated current values can be further processed in different manners. For instance, the calculated current values can be sent to user-specific software applications, where they can be processed depending on the requirements of the specific application. Typically, however, the calculated electrical current values will be displayed in a numerical or graphical form. Consequently, in one embodiment, the method of the present invention further comprises the step of g) displaying said calculated electrical current values $I_j$. For instance, the method of the present invention can be implemented in a measurement device having an integrated display showing calculated electrical current values as numerical values or on a chart as graphical values. The measured electrical current values can also be transferred to a stationary or mobile computer device, such as a mobile phone or a tablet computer, which runs a software application for displaying the calculated electrical current values.

The number M of measurements at sampling frequency fs are at least performed once in order to obtain the required minimum data set for performing a discrete Fourier transformation. Preferably, however, the number of M measurements are repeated sequentially. Therefore, in one embodiment of the method of the present invention, the above described steps b) to g) are repeated during consecutive measurement cycles. In this case, when displaying the calculated electrical current values, it can be advantageous to display only an average value over several measurement cycles in order to have a smoother visual representation of the measurement data.

Preferably, the harmonic analysis, specifically the discrete Fourier transformation, used in step c) of the method of the present invention is a Fast Fourier Transformation (FFT). FFT is a fast and efficient algorithm for implementing a discrete Fourier transformation.

When FFT is used as a discrete Fourier transformation, the number M of measurements is preferably selected from the group consisting of 128, 256, 512, 1024 and 2048. Other values for the number M of measurements can, however, also be employed. Typical number of measurements, usually denoted as "*block length*", is an integer power to base 2, for instance $2^{12}$ corresponds to a block length of 4,096 samples. However, a larger block length increases the time required for one measurement (measurement time for one measurement cycle = block length / sample frequency).

The sample frequency not only influences the measurement time, but also the band width, i.e. the theoretical maximum frequency, which can be evaluated via an FFT, also denoted Nyquist frequency. Accordingly, the sampling frequency fs should at least be twice as high as the current frequency fc of electrical currents flowing in the multi-conductor cable. In one embodiment of the method of the present invention, the sampling frequency fs is selected from a range of 200 Hz to 3.2 kHz. Preferably, the sampling frequency fs is selected from a range of 400 Hz to 1 KHz.

The sampling frequency fs and the number M of measurements are typically adapted to the expected or known current frequency fc to allow for an efficient implementation of the method of the present invention.

For instance, in in many areas of the world the standard frequency of electrical currents in household or industrial environments, i.e. the grid frequency, is either 50 Hz or 60 Hz. A preferred embodiment of the method of the present invention which works equally well for both grid frequencies uses a sampling frequency which corresponds to a first integer multiple of 50 Hz and a second integer multiple of 60 Hz. The number M of measurements is then preferably selected as an integer multiple of both said first integer multiple and said second integer multiple, respectively. For instance, using sampling frequency fs of 900 Hz (i.e. one measurement every 1.111 ms) corresponds to a first integer multiple of 18 (@ 50 Hz) and a second integer multiple of 15 (@ 60 Hz). Using a number M of measurements equal to 90 (M= 90) corresponds to 5 complete periods of a 50 Hz signal and 6 complete periods of a 60 Hz signal. Accordingly, the method of the present invention can be implemented very efficiently on a microprocessor.

As indicated above, the first direction x and the second direction y lie preferably within the same plane, mainly the plane of the aperture of the sensor head. Preferably, the third direction z, i.e. the direction in which the multi-conductor cable extends when arranged within the sensor head, is perpendicular to the plane established by the first direction x and the second direction z. In such an embodiment, measurements of the magnetic field components $H_x$ and $H_y$ in the first and second directions, respectively, is sufficient to calculate the electrical currents flowing in each conductor, because the magnetic field pattern is independent from the third direction, also denoted as z-direction, as long as the cable is perfectly aligned in the third direction z.

However, measurement of the magnetic field component $H_z$ in the third direction z can be used to verify that the cable is correctly aligned. Accordingly, if the magnetic field component in the third direction z is measured, this measurement can be used to properly align the cable by minimizing the corresponding magnetic field component $H_z$.

Consequently, in one embodiment of the method of the present invention, the first direction x is perpendicular to said third direction z, and said second direction y is perpendicular to said third direction z, and wherein said step b) further comprises performing said number M of measurements at said sampling frequency fs of a magnetic field $\vec{H}$ in said third direction z. The measured component of the magnetic field in the search direction z, i.e. $H_z$, can be displayed as a numerical value. Alternatively, as the magnetic field component $H_z$ is essentially an indication of a correct alignment of the multi-conductor cable in the sensor head; this value can be used as a mere indication of the correct alignment, for instance by displaying an error when the magnetic field component $H_z$ exceeds a pre-defined threshold. In another embodiment, the components of the magnetic field in all three directions $H_x$, $H_y$, $H_z$ can be employed to calculate the desired electrical current I.

In order to distinguish between magnetic field components induced by currents flowing in the multi-conductor cable and other external sources of magnetic fields, reference measurements can be conducted. For instance, if it is feasible to switch the electrical current on and off, measurements during the off-phase can be used as reference measurements. As this is not always feasible, in certain embodiments, magnetic field measurements obtained by reference magnetic sensors can be employed. In one embodiment of the method of the present invention, the sensor head further comprises at least one reference magnetic sensor spaced apart from said inner surface of said aperture of said sensor head. The first and second components $H_x$, $H_y$ of said magnetic field $\vec{H}$ are obtained by including corrections $Href_x$, $Href_y$ obtained from said at least on reference magnetic sensor. The at least one reference magnetic sensor is arranged at a distance from the center of the multi-conductor cable which is at least twice the distance, preferably, at least five times the distance and particularly preferred at least ten times the distance of the distance of the magnetic sensors used for measuring the magnetic field components $H_x$ and $H_y$. In embodiments where the third component $H_z$ of the magnetic field is also employed to evaluate the desired electrical current, the corrections can also include a component $Href_z$ from said at least one reference magnetic sensor.

The current frequency fc can either be a pre-determined frequency, for instance if it is known, that the current frequency is the regular net frequency or grid frequency. Alternatively, the current frequency fc can be determined experimentally from the measured magnetic field.

In one embodiment of the method of the present invention, the in step d) said current frequency fc is a pre-selected current frequency. This variant is particularly preferred if the current frequency is known in advance.

If the current frequency fc is not known in advance, the frequency can be determined from the data of the discrete Fourier transformation. Often, the coefficient with the largest frequency component can be considered as representing the current frequency fc. However, as the corresponding frequency resolution $\Delta f$ is equal to the sample frequency fs divided by the block length, a higher resolution can be obtained by varying the sample frequency. Accordingly, in another embodiment of the method of the present invention, in step d) said current frequency fc is determined by varying said sampling frequency fs in step b) in consecutive measurement cycles and by selecting in step e) the frequency having the largest magnetic field amplitude coefficient as the current frequency fc. Typically, the sample frequency fs is varied by at least 5%, in some cases by at least 10 %, of the expected current frequency fc.

In certain embodiments, in step e) the magnetic field amplitude coefficients are selected which correspond to said current frequency (fc) from said frequency distributions. The method of the present invention then yields in step f) the electrical currents values $I_j$ at that specific current frequency. This leads to accurate current measurements as long as the electrical current is essentially sinusoidal or as long as the current value at a particular frequency, e.g. at the fundamental frequency of the signal is desired.

However, in many cases an electrical current is not sinusoidal but still periodic and other frequency components in addition to the fundamental frequency may contribute to the overall signal. In such cases, rather than measuring the current at a particular current frequency fc, it is preferable measuring the root mean square (RMS) of the current signal. Typically, RMS measurements are effected in the time domain. However, according to Parseval's theorem or Parseval's identity, the energy of a periodic signal, given as the integral of the squared amplitude of the signal in the time domain, is equal to energy of its frequency domain representation, given as the sum of squares of the amplitudes. Stated differently, the total energy or power of the signal is preserved under Fourier transform. Accordingly, the discrete Fourier transform (DFT) of a periodic electrical current signal i(t) is a given by the formula

$$I(k\Delta f) = \sum_{n=0}^{M-1} i(n\Delta t)e^{-i(2\pi k\Delta f)(n\Delta t)}$$

for k = 0, 1, 2, ..., M-1, where M is the total number of measurements, $\Delta t$ = 1/fs the time between data points. The sampling time T is given as T = M·$\Delta t$ and the frequency increment in the frequency domain as $\Delta f$ = 1/T. The frequency increment $\Delta f$ of a DFT is analogous to the fundamental frequency of a Fourier series. However, unlike a Fourier series, the frequency increment $\Delta f$ is generally not related to the fundamental frequency of the original time domain signal because, as long as the fundamental frequency is not known, the total sampling time T is an arbitrary time period. However, as soon as the fundamental frequency of the electrical current is known, the sampling time T can be adapted to avoid errors associated with arbitrary time periods.

In the frequency domain, the RMS value of the electrical current $I_{RMS}$ is given as

$$I_{RMS} = \sqrt{\frac{1}{M} \sum_{k=0}^{M-1} I(k\Delta f)^2}$$

where I(k∆f) is the value of the k-th frequency component obtained from the DFT as described above.

A more efficient implementation of the determination of the RMS current value uses only half of the M measurements. Consequently, current I$_{RMS}$ can also be calculated as

$$I_{RMS} = \sqrt{\frac{1}{M/2} \sum_{k=0}^{M/2-1} I(k\Delta f)^2}$$

Further, when only contributions resulting from alternating current components are required, the DC component at k= 0 can be ignored, so that I$_{RMS}$ is given as

$$I_{RMS} = \sqrt{\frac{1}{\frac{M}{2}-1} \sum_{k=1}^{M/2-1} I(k\Delta f)^2}$$

Ignoring the DC component also has the additional benefit that contributions from other external static magnetic stray fields, especially the earth magnetic field are disregarded, thus improving measurement accuracy.

Accordingly, in certain embodiments of the method of the present invention, in step e) magnetic field amplitude coefficients which correspond more than one frequency from said frequency distributions of said measurement data are selected and in step f) the root mean square (RMS) of the electrical current (I$_{RMS}$) is calculated.

The electrical current values in each conductor can be calculated from at least the first and second components of the magnetic field in various manners.

According to one embodiment of the method of the present invention, in step f), said electrical currents values I$_j$ for currents flowing in each conductor of said multi-conductor cable are calculated from a trained artificial intelligence model. Accordingly, an artificial intelligence model can, for instance be trained by using a multitude of different cable configurations, which can vary in terms of the number of conductors, the geometrical arrangement of the conductors within the cable, i.e. especially the distance of the conductors from one another and in terms of the electrical current values and current frequencies and possible phase differences of the currents flowing through each individual conductor. From a given configuration, it is straightforward to calculate the resulting components of the magnetic field at the location of each magnetic sensor. The inverse operation, i.e. calculating the respective currents from measured magnetic field components, is, however, not analytically solvable. However, a correspondingly trained artificial intelligence model is able to assign a certain electrical current parameter set to an observed pattern of magnetic field components. The training of the artificial intelligence model does not have to be conducted experimentally, i.e. by passing certain currents through various configurations of cables and actually measuring the resulting magnetic field components, but by simulating magnetic field patterns based on certain model calculations of cable configurations. Accordingly, a huge training set for the artificial intelligence model can be efficiently provided at low cost.

Alternatively, the equations determining the magnetic field strength at the location of the magnetic sensors can be formulated analytically, while the inverse operation has to be solved numerically.

In another embodiment of the method of the present invention, in step f), said electrical currents values I$_j$ for currents flowing in each of N individual conductors, i.e. *j = 1 to N,* of said multi-conductor cable, are calculated from magnetic field measurements of *L* magnetic sensors for the x- and y-components, respectively, arranged at different locations, by numerically solving equations

$$H_{ix} = -\frac{1}{2\pi} \left( \sum_{j=1}^{N} I_j \frac{\Delta y_{ij}}{r_{ij}^2} \right)$$

and

$$H_{iy} = \frac{1}{2\pi}\left(\sum_{j=1}^{N} I_j \frac{\Delta x_{ij}}{r_{ij}^2}\right)$$

for *i= 1 to L,* wherein $r_{ij}$ is the distance between magnetic sensor *i* and conductor *j* and $\Delta x_{ij}$ and $\Delta y_{ij}$ are the respective x- and y-components of said distance.

Preferably, the origin of the x-y-coordinate system is located at one pre-determined magnetic sensor. If all magnetic sensors used in the sensor head are run the same type, such a selection of the origin of the coordinate system allows to compensate for absolute locations and absolute dimensions of the multiplicity of magnetic sensors, so that only the relative arrangement of the sensors to the sensor chosen as origin are relevant for evaluating the numerical solution.

Accordingly, a much greater precision than the actual dimensions of the magnetic sensor can be obtained assuming that all sensors respond similarly to magnetic fields in their surrounding.

Various methods for solving the above equations can be employed, for instance a modified Newton algorithm and the like.

In many use cases of the method of the present invention, the cable to be measured does not run exactly parallel to the central axis of the aperture and/or the conductors or wires of the cable are twisted, so that the electric current flowing through the conductors does not only generate a magnetic field component in the first and second directions (x and y directions) but also a component in said third direction (z direction). Therefore, in certain embodiments of the present invention, in step b) said number (M) of measurements of said magnetic field ($\vec{H}$) at said sampling frequency (fs) are further performed in said third direction (z) at each of said number (L) of different locations, to obtain said number (M) of measurement data for each of said first, second and third directions (x, y, z).

The present invention also concerns a device for non-intrusive current measurement in at least one electrical conductor comprising:

a sensor head comprising one or more magnetic sensors arranged at a number of different locations at said inner surface ,

a processing unit functionally connected with said magnetic sensors , said processing unit being configured to execute at least steps b) to f) of the above described method of the present invention. The processing unit can be a microcomputer running a software to execute steps b) to f), and optionally g).

The term "sensor head" is to be construed in a very broad sense referring to any arrangement of one or more magnetic sensors as distinct from the processing unit which evaluates the magnetic field measurement data obtained from the magnetic sensors. Consequently, in the broadest sense, a single magnetic sensor can constitute a "sensor head" in the sense of the present invention.

In certain embodiments of the invention the sensor head comprises an aperture defined by an inner surface of said sensor head, said aperture having an inner diameter (D) and a central axis (A). Said one or more magnetic sensors are arranged at said number of different locations at said inner surfaced of the aperture.

In certain embodiments, the one or more conductors are arranged in a cable, for instance a multi-conductor cable.

Consequently, the present invention also concerns a device for non-intrusive current measurement in a multi-conductor cable comprising:

a sensor head comprising an aperture defined by an inner surface of said sensor head , said aperture having an inner diameter (D) and a central axis (A), and a multiplicity of magnetic sensors arranged at a number of different locations at said inner surface ,

a processing unit functionally connected with said multiplicity of magnetic sensors , said processing unit being configured to execute at least steps b) to f) of the above described method of the present invention. The processing unit can be a microcomputer running a software to execute steps b) to f), and optionally g).

The aperture can have any configuration suitable of arranging the magnetic sensors closely to the multi-conductor cable. As most cables have a circular cross-section, it is preferred that the aperture also has an essentially circular configuration. In this context, the term *"aperture"* does not necessarily imply that it is delimited by a closed circumference, but the circumference can have an opening allowing the introduction of the cable from the outside. Preferably, however, the aperture includes movable parts, which allow to obtain an essentially closed configuration after introduction of the cable to be measured.

If the aperture has an essentially circular configuration, the term "inner diameter" refers to the actual inner diameter of the circle. However, the aperture can also exhibit any suitable non-circular configuration, for instance a U-shaped configuration or an elliptical configuration. In these cases, measurement of cables having a circular cross-section will still be the most relevant application. Therefore, in the context of the present invention, for apertures exhibiting a non-circular configuration, the "inner diameter" of the aperture refers to the diameter of the largest circle which can be inscribed into the aperture.

In one embodiment of the device of the present invention, the aperture is defined by at least two sections of said sensor head, which are movable with respect to each other in order to provide an aperture with variable diameter D. The two sections can be configured as movable clamps or jaws, which, in the closed position, result in a more or less circular configuration. With only two sections, such a circular configuration can only be approximated; in an alternative embodiment, the sections consist of a multiplicity of lamellar elements, which allow a better approximation of a circular approach, essentially similar to a lamellar diaphragm often used in photographic cameras. Depending on the configuration of the sections and the resulting diameter of the aperture, certain magnetic sensors of the multiplicity of magnetic sensors can be less effective in determining the magnetic field components because they might be arranged at a greater distance from the multi-conductor cable than other magnetic sensors. Therefore, the device and method of the present invention also provide for selecting only a sub-set of the multiplicity of magnetic sensors for evaluating the currents flowing through the conductors, provided that the sub-set still meets the requirement that the resulting number of locations is larger than the number of individual conductors in the cable.

In one embodiment of the device of the present, the sensor head comprises guiding means which ensure a perpendicular alignment of a section of the cable passing through the aperture with respect to a plane in which the multiplicity of magnetic sensors are arranged. The guiding means can comprise an open channel essentially extending a certain length from the aperture in a direction perpendicular to the aperture. Preferably, the guiding means extend from both sides of the aperture. For typical electrical cables, the certain length can be in a range of 5 to 40 mm, preferably from 10 to 30 mm.

In one embodiment, the device of the present invention is a handheld device, i.e. a device which is configured to be gripped by the hand of person, e.g. by including a suitable handle.

In one embodiment of the handheld device of the present invention, the processing unit comprises a microprocessor arranged in said sensor head and a mobile device removably connectable to said sensor head. In such an embodiment, the implementation of the method of the present invention can be distributed between the microprocessor arranged in the sensor head and the microcomputer arranged in the mobile device. For instance, a microprocessor in the sensor head can essentially implement the data acquisition and data communication processes, while the actual evaluation of the magnetic fields in order to calculate the respective electrical currents is handled by the microcomputer of the mobile device.

In another embodiment, the device of the present invention is a stationary device which can be permanently installed or mounted on a cable. In such a case, the sensor head can be configured as a sensor ring surrounding the cable to be measured. The processing unit can be included in in the sensor head or can be remotely connected to the sensor head, either via a wired connection or a wireless connection.

The device of the present invention can include energy harvesting means which use a small portion the energy transmitted in the cable to be measured to power the device itself. Typically, near-filed wireless power techniques are employed, using e.g. magnetic fields of the cable via inductive coupling or electric fields of the cable via capacitive coupling.

The sensor head and processing unit can also be integrated on a circuit board or on a chip allowing to save space and costs as compared to prior art devices.

The stationary devices can be used in a vast variety of areas where current through electrical cable as to be measured ranging from energy generators to transportation devices such as electric vehicles or space vehicles.

The invention will now be described in more detail in connection with an embodiment depicted in the accompanying drawings.

In the drawings:

Fig. 1   shows a schematic cross-sectional view of one embodiment of a handheld device according to the present invention, having a sensor head with a U-shaped aperture;

Fig. 2   shows a schematic cross-sectional view of another embodiment of a handheld device of the present invention having a sensor head with variable aperture;

Fig. 3   shows a schematic cross-sectional view of a first stationary embodiment of the present invention; and

Fig. 4   shows a schematic cross-sectional view of a second stationary embodiment of the present invention.

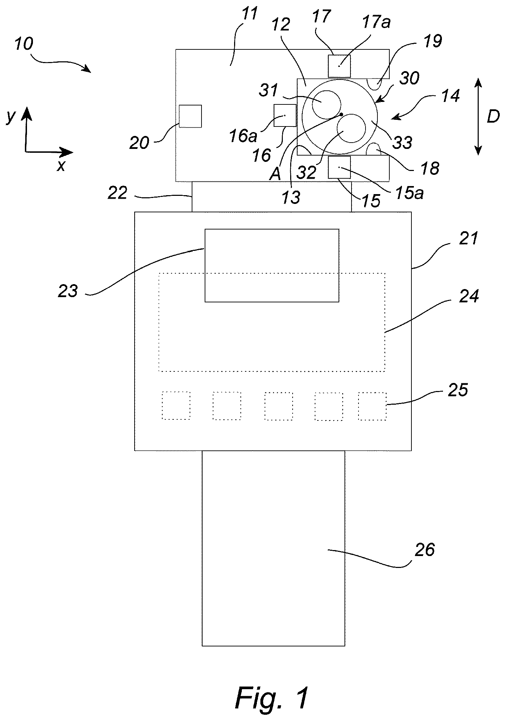

In Fig. 1 a schematic cross-sectional view of a first embodiment of a handheld device 10 according to the present invention is shown. The handheld device 10 comprises a sensor head 11 having a U-shaped aperture 12 which is defined by an inner surface 13 of the sensor head 11. The aperture has a central axis A which is perpendicular to the plane of the drawing. The U-shaped aperture 12 has an open side inlet 14 that allows insertion of a cable. In the embodiment of Fig. 1, the sensor head 11 is provided with three magnetic sensors, namely a first magnetic sensor 15, a second magnetic 16, and a third magnetic sensor 17. The three magnetic sensors 15, 16, 17 are arranged in a T-shaped configuration at three different locations at the inner surface 13 of the sensor head 11. In the present example, each magnetic sensor 15, 16, 17 is a fully integrated 3-axis magnetometer with integrated electronic circuits. Such magnetometers are commercially available, e.g. the AMR magnetometer MMC5983MA, manufactured by the company MEMSIC Semiconductor Co., Ltd. This MEMSIC magnetometer has a measurement range of +/- 800 $\mu$T and allows of up to 18 bits operation corresponding to an resolution of 0.006 $\mu$T. At 16 bits operation, the resolution is still 0.024 $\mu$T. The MEMSIC magnetometer of this embodiment has dimensions of 3 x 3 x 1 mm. However, using identical magnetic sensors in the sensor head and choosing the same location on each magnetic sensor as reference points to which the measured magnetic fields refer, e.g. the centers 15a, 16a, 17a of each magnetic sensor 15, 16, 17, respectively, allows for a much higher spatial resolution, because the internal arrangements and the exact point of maximum sensitivity within the sensor do not matter under these circumstances, provided that these features are essentially the same for all sensors installed. A configuration according to the first embodiment using three two-axis or three axis magnetometers allows the evaluation of currents in cables having two conductors. In this embodiment, the U-shaped aperture 12 of the sensor head 11 has an inner diameter D of 12 mm allowing to accommodate most common two-conductor cables and can be provided with inwardly facing first and second protrusions 18, 19 near the side inlet 14 allowing to maintain a cable 30 to be investigated, also shown schematically in Fig. 1, in place. For the present example of a U-shaped aperture, the inner diameter essentially corresponds to the width in the y-direction of Fig. 1 (see coordinate system indicated in the Fig. 1).

In Fig. 1, the cable 30 has two conductors 31, 32 surrounded by a protective sheath 33. Usually, the sheath is made from a flexible plastic material allowing the cable to be squeezed through the gap formed between the first and second protrusions 18, 19. The protrusions 18, 19 can also be made from material exhibiting some flexibility to avoid damage of the cable.

As can be taken from Fig. 1, in this embodiment, the sensor head 11 further comprises a reference magnetic sensor 20 which is arranged at much a larger distance from the cable 30 than the magnetic sensors 15, 16, 17. The reference magnetic sensor is typically employed to correct for external magnetic fields if DC currents are to be measured in the cable or, if AC currents are measured, if the measurement takes place in an environment having a strong background at the measurement frequency.

In the embodiment of Fig. 1, the handheld device 10 comprises a body 20 to which the sensor head 11 is removably attached via a connector 21. The connector 21 provides not only a mechanical connection between sensor head 11 and body 20 but also a data connection between magnetic sensors 15, 16, 17, the reference magnetic sensor 20 and a microprocessor 23 arranged in the body 21. The microprocessor 23 is programmed to carry out the method of the present invention. The body 20 of the handheld device 10 further comprises a display 24 and control buttons or control knobs 25 for data output/visualization and data input. As the display 24 and the control buttons/knobs 25 are shown in dotted lines because these elements are not arranged in the plane of the cross-sectional view of Fig. 1. Finally, the body 11 is provided with a handle 26 which can be grasped by the user.

Based on the geometrical configuration of Fig. 1, the two-conductor cable (*N=2*) can be evaluated as follows:

- Given values are the known locations of the first magnetic sensor 15, the second magnetic sensor 16 and the third magnetic sensor 17, i.e. the coordinates in the x-y-coordinate system in the plane of Fig. 1: $(m_{1x}, m_{1y})$, $(m_{2x}, m_{2y})$ and $(m_{3x}, m_{3y})$. The origin of the coordinate system and be anywhere with respect to the sensor head but is preferably chosen to be in the center (or any other pre-selected point) on one of the magnetic sensors, e.g. the first magnetic sensor such that $m_{1x}=0$ and $m_{1y} = 0$.

- Measured values are the magnetic B-field components measured by the three magnetic sensors (*L=3*) in the x-y plane which can be converted into corresponding magnetic H-field components, i.e. $(H_{1x}, H_{1y})$, $(H_{2x}, H_{2y})$ and $(H_{3x}, H_{3y})$.
- Unknowns are the currents $I_1$, $I_2$ flowing in each cable and the exact location of each of the two conductors in the cable $(x_1, y_1)$, $(x_2, y_2)$.

These six unknowns are related to the known and measured values via the following six equations, where the distance $r_{ij}^2$ between magnetic sensor $i$ and conductor $j$ is expressed in terms of the respective x and y components $(m_{ix}-x_j)^2$ and $(m_{iy}-y_j)^2$:

$$H_{1x} = -\frac{I_1}{2\pi}\left(\frac{m_{1y} - y_1}{(m_{1x} - x_1)^2 + (m_{1y} - y_1)^2}\right) - \frac{I_2}{2\pi}\left(\frac{m_{1y} - y_2}{(m_{1x} - x_2)^2 + (m_{1y} - y_2)^2}\right)$$

$$H_{1y} = \frac{I_1}{2\pi}\left(\frac{m_{1x} - x_1}{(m_{1x} - x_1)^2 + (m_{1y} - y_1)^2}\right) + \frac{I_2}{2\pi}\left(\frac{m_{1x} - x_2}{(m_{1x} - x_2)^2 + (m_{1y} - y_2)^2}\right)$$

$$H_{2x} = -\frac{I_1}{2\pi}\left(\frac{m_{2y} - y_1}{(m_{2x} - x_1)^2 + (m_{2y} - y_1)^2}\right) - \frac{I_2}{2\pi}\left(\frac{m_{2y} - y_2}{(m_{2x} - x_2)^2 + (m_{2y} - y_2)^2}\right)$$

$$H_{2y} = \frac{I_1}{2\pi}\left(\frac{m_{2x} - x_1}{(m_{2x} - x_1)^2 + (m_{2y} - y_1)^2}\right) + \frac{I_2}{2\pi}\left(\frac{m_{2x} - x_2}{(m_{2x} - x_2)^2 + (m_{2y} - y_2)^2}\right)$$

$$H_{3x} = -\frac{I_1}{2\pi}\left(\frac{m_{3y} - y_1}{(m_{3x} - x_1)^2 + (m_{3y} - y_1)^2}\right) - \frac{I_2}{2\pi}\left(\frac{m_{3y} - y_2}{(m_{3x} - x_2)^2 + (m_{3y} - y_2)^2}\right)$$

$$H_{3y} = \frac{I_1}{2\pi}\left(\frac{m_{3x} - x_1}{(m_{3x} - x_1)^2 + (m_{3y} - y_1)^2}\right) + \frac{I_2}{2\pi}\left(\frac{m_{3x} - x_2}{(m_{3x} - x_2)^2 + (m_{3y} - y_2)^2}\right)$$

These equations cannot be resolved for $I_1$, $I_2$ analytically. Rather, AI methods or numerical methods have to be employed.

An example of a suitable numerical method for solving the above referenced six equations for the two unknown currents $I_1$, $I_2$ and the four unknown distances is essentially a modified Newton method and can be summarized as follows:

a) an six-dimensional initial starting vector $\vec{V_0}$ is created having components which are estimated solutions for $I_1$, $I_2$, $r_{1x}$, $r_{1y}$, $r_{2x}$, $r_{2y}$;

b) from the above equations, a six-dimensional error vector $\vec{E_0}$ is determined which indicates the deviation of the measured magnetic field values from those calculated on the basis of the initial starting vector $\vec{V_0}$;

c) an error measure $EM_0$ is determined as the sum of the absolute values of each component of error vector $\vec{E_0}$;

d) a Jacobian 6x6 matrix $J_0$ is calculated which includes the partial derivatives of the above magnetic field equations at the values of the starting vector;

e) the Jacobian is inverted to yield $J_0^{-1}$;

f) a correction vector $\vec{K_0} = J_0^{-1} * \vec{E_0}$ is formed;

g) a new starting vector $\vec{V_1}$ is formed according to $\vec{V_1} = \vec{V_0} + \lambda_0 * \vec{K_0}$, with factor $\lambda_0$ being selected from the range $0 \leq \lambda_0 \leq 1$ by varying $\lambda$ until the error measure functions $EM(\lambda)$ becomes minimal, which can, for instance be achieved using a gradient descent approach;

h) steps b) to g) are repeated with the result g), i.e. determining error vector $\vec{E_i}$ from starting vector $\vec{V_i}$ error measure $EM_i$, Jacobian $J_i$, correction vector $\vec{K_i}$, and new starting vector $\vec{V_{i+1}}$ ;

i) loop b) to g) is stopped either when EM is smaller than a pre-defined threshold and the resulting vector $\vec{V_i}$ is the desired solution, or when a pre-defined number of loops has been reached without EM converging below said threshold;

j) in the latter case of step i), steps a) to i) can be repeated with a new initial starting vector.

The pre-defined threshold can be zero within the accuracy of the computer implementing the above method.

In certain cases, the modified Newton method described above allows small disturbances in $H_{x,y,z}$ to lead to incorrect results, even if the method still converges. This can be recognized, for example, by the fact that unrealistic values are obtained for the spacing of the conductors of the cable. In order to overcome such problems, a variant of the method of the present invention suggests using an improved estimation:

Firstly, two vectors W and Wz are defined, where

W is the sum of the vector lengths of the x, y components of the magnetic field measured by the individual sensors, i.e. $W = W_1 + W_2 + W_3$, and

$W_z$ is the sum of the vector lengths of the x, y, z components of the magnetic field measured by the individual sensors, i.e. $W_z = W_{1z} + W_{2z} + W_{3z}$ with:

$$W_1 = \sqrt{H_{1x}{}^2 + H_{1y}{}^2} \;,\; W_2 = \sqrt{H_{2x}{}^2 + H_{2y}{}^2} \;,\; W_3 = \sqrt{H_{3x}{}^2 + H_{3y}{}^2}$$

and

$$W_{1z} = \sqrt{H_{1x}{}^2 + H_{1y}{}^2 + H_{1z}{}^2} \;,\; W_{2z} = \sqrt{H_{2x}{}^2 + H_{2y}{}^2 + H_{2z}{}^2} \;,\; W_{3z} = \sqrt{H_{3x}{}^2 + H_{3y}{}^2 + H_{3z}{}^2}$$

In the ideal case (parallel cores), the z component is zero and W = Wz applies.

Furthermore, W is generally proportional to the current I, i.e. I = p W,
i.e. the task is to determine the proportionality factor p.

In real world application cables are usually tilted or even twisted in relation to the sensors, i.e. the W and $W_z$ are generally different, however, there is still a proportionality between vector W, $W_z$ and current I, but with different proportionality factor p depending on the situation. In such cases it is suggested to reconstruct the electrical current I from W and $W_z$ using artificial intelligence methods.

According to one embodiment, a neural network is trained numerically in order to determine the proportionality factor p and finally the electrical current I from the measured values. The neural network can be trained, for example, by simulating certain cables with different tilt angles, which represent the twisting between the conductors and/or a tilting of the cable as a whole. It is therefore not necessary to calculate the magnetic field of the entire twisted cable. From measured data, the trained neural network than provides an estimation function. Essentially, the trained neural network can be regarded as a linear regression method in which the matrix is represented by the trained weight values of the neural network nodes.

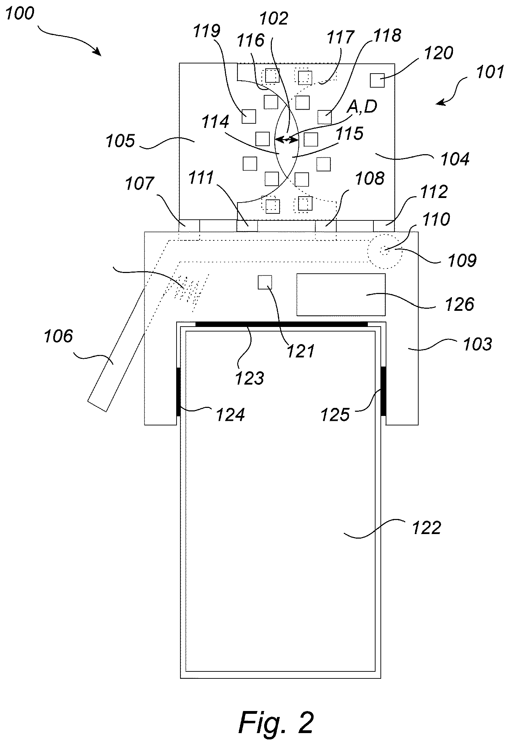

Fig. 2 shows schematically a cross-sectional view of a second embodiment of a handheld device 100 according to the present invention, which comprises a sensor head 101 with variable aperture 102 and a body 103. In Fig. 2, elements which are covered by elements lying in the plane of Fig 2 are shown in dotted lines. In this embodiment, the sensor head 101 comprises two essentially identical first and second sections 104, 105, wherein the second section 105 is pivotable with respect to the static first section 104. To this effect, the second section is attached to a handle 106 by means of feet 107, 108 and the handle 106 is pivotally hinged to a ball bearing 109 arranged around a rotary axis 110 in the body 103 of the handheld device 100. The static first section 104 of the sensor head 101 is attached to the body 103 by means of feet 111, 112. To open or enlarge the aperture 102, the user can grasp the handle 106 and urge it towards the body 103 against the force of a return spring 113. If no force acts upon the handle 106, the return spring 113 urges the second section 105 towards the first section 104, thus defining an aperture 102 with minimum diameter as depicted in Fig. 2. When the handle 106 is pressed against the force of the return spring 113, the second section 105 moves away from the first section 105 allowing to introduce a multi-conductor cable (not depicted in Fig. 2) into the aperture 102 which is in this embodiment defined by two recesses 114, 115 arranged in each of the first and second sections 104, 105 with the first and second section 104, 105 being arranged such that the respective recesses 114, 115 face each other in the closed position. Each recess has an inner surface 116, 117, respectively, at which a multiplicity of magnetic sensors is arranged. In the present embodiment, nine magnetic sensor 118 are arranged in the static first section 104 of the sensor head 101 and nine magnetic sensors are arranged in the pivotable second section 105 of the sensor head 101. When the multi-conductor cable is in circuit into the aperture 102, the handle 106 is released and the return spring 113 acting on the handle 106 urges the second section 105 towards the first section 104 until the diameter of the aperture essentially corresponds to the diameter of the inserted cable. This arrangement allows at least some of the sensors of the sensor head to be as close to the multi-conductor cable as possible, therefore increasing measurement accuracy.

As can also be seen in Fig. 2, the sensor head 101 comprises two reference magnetic sensors 120, 121 spaced further apart from the aperture to allow for a compensation of external magnetic fields. A first reference magnetic sensor 120 is arranged at an opposite side magnet A first reference magnetic sensor 120 is disposed at an end of the first section 104 opposite the recess 114 of the first section. A second reference magnetic sensor 121 is disposed in the body 103, thus being spaced even further apart from the aperture 102 than the first reference magnetic sensor 120.

In the present example, the body 103 of the handheld device 100 is configured as connector interface to be attached to a mobile device, for instance a smart phone 122 which can then serve as a gripping handle of the whole device. In the present embodiment, the body comprises a physical data connector 123 and two mechanical connectors 124, 125 to provide a rigid assembly of body 103 and smart phone 122. The mobile device/smart phone 122 can be configured with a software application which allows to conduct the necessary calculation for obtaining the desired electrical currents from the magnetic fields measured at a multiplicity of magnetic sensors in accordance with the method of the present invention. In this case, the body 103 head comprises merely a microcircuit 126 which essentially controls data acquisition of the magnetic sensors and data transfer towards the mobile device/smart phone 122. This can, for instance, be effected via the physical data connector 123, which can, e.g., be a USB-C connector. It is also possible that data transfer is effected wirelessly, for instance a Bluetooth-connection between the microcircuit 126 and the mobile device/smart phone 122.

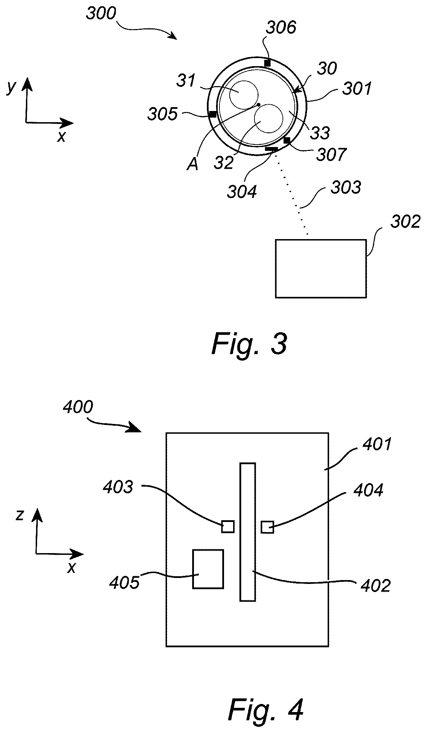

Fig. 3 shows a schematic cross-sectional view of a first stationary embodiment of the present invention. The stationary device 300 comprises a sensor head 301 configured as a sensor ring which surrounds a cable, e.g. the cable 30 of Fig. 1, i.e. a cable which includes a first conductor 31, a second conductor 32 and a sheath 33. Similar to the handheld embodiments, the sensor head 301 comprises an aperture having a central axis A along which the cable 30 passes through the aperture. The sensor head 301 further includes a transmitter 303 which allows the sensor head to be remotely connected to a processing unit 302 via a wireless connection 304. Similar to the handheld embodiments, the sensor head 301 includes magnetic sensors 305, 306, 307 for measuring the magnetic field produced by conductors 31, 32.

Fig. 4 shows a schematic plane view of second stationary embodiment of the present invention. In this embodiment, the stationary device 400 is integrated on printed circuit board 401 which comprises a printed electrical conductor 402. The current flowing through the conductor 402 is measured via two magnetic sensors 403, 404. The processing unit 405 is also integrated on the printed circuit board. In this view, the z-direction in which the conductor extends and the x-direction are in the plane of the circuit board 401 and the y-direction (not shown) is perpendicular to the circuit board.

List of Reference Signs

| | |
|---|---|
| 10 | first embodiment of handheld device |
| 11 | sensor head |
| 12 | U-shaped aperture |
| 13 | inner surface |
| 14 | side inlet |
| 15 | first magnetic sensor |
| 15a | center of first magnetic sensor |
| 16 | second magnetic sensor |
| 16a | center of second magnetic sensor |
| 17 | third magnetic sensor |
| 17a | center of third magnetic sensor |
| 18 | first protrusion |
| 19 | second protrusion |
| 20 | reference magnetic sensor |
| 21 | body |
| 22 | connector |
| 23 | microprocessor |
| 24 | display |
| 25 | control button/knob |
| 26 | handle |
| 30 | cable |
| 31 | first conductor |
| 32 | second conductor |
| 33 | sheath |
| 100 | second embodiment of handheld device |
| 101 | sensor head |
| 102 | variable aperture |
| 103 | body |
| 104 | static first section of sensor head |
| 105 | pivotable second section of sensor head |
| 106 | handle |
| 107 | foot of second section |
| 108 | foot of second section |
| 109 | ball bearing |
| 110 | rotary axis |
| 111 | foot of first section |
| 112 | foot of first section |
| 113 | return spring |
| 114 | recess of first section |

| | |
|---|---|
| 115 | recess of second section |
| 116 | inner surface of recess of first section |
| 117 | inner surface of recess of second section |
| 118 | magnetic sensors of first section |
| 119 | magnetic sensors of second section |
| 120 | reference magnetic sensor |
| 121 | reference magnetic sensor |
| 122 | smart phone |
| 123 | data connector |
| 124 | mechanical connector |
| 125 | mechanical connector |
| 126 | microcircuit |
| 300 | first embodiment of a stationary device |
| 301 | sensor head / sensor ring |
| 302 | processing unit |
| 303 | transmitter |
| 304 | wireless connection |
| 305-307 | magnetic sensors |
| 400 | second embodiment of a stationary device |
| 401 | printed circuit board |
| 402 | printed electrical conductor |
| 403. 404 | magnetic sensors |
| 405 | processing unit |
| A | central axis |
| D | diameter of aperture |

**Claims**

1. A method for non-intrusive current measurement in at least one electrical conductor, comprising the steps of:

    a) arranging one or more magnetic sensors (15, 16, 17, 118, 119, 305, 306, 307, 403, 404) at a number (L) of different locations adjacent to a number (N) of individual electrical conductors, said conductors extending in a third direction (z);

    b) performing a number (M) of measurements at a sampling frequency (fs) of a magnetic field ($\vec{H}$) at least in a first direction (x) making a first angle with said third direction (z) and in a different second direction (y) making a second angle with said third direction (z), at each of said number (L) of different locations, to obtain said number (M) of measurement data for each of said first and second directions (x, y);

    c) performing a harmonic analysis, preferably a discrete Fourier transformation, on each set of said number (M) of measurement data for each of said first and second directions (x, y) to obtain frequency distributions of said measurement data;

    d) determining a current frequency (fc) of electrical currents (I) flowing in said conductors;

    e) selecting magnetic field amplitude coefficients which correspond at least to said current frequency (fc) from said frequency distributions of said measurement data to obtain a first component ($H_x$) of said magnetic field ($\vec{H}$) in said first direction (x) and of a second component ($H_y$) of said magnetic field ($\vec{H}$) in said second direction (y) at each of said number (L) of different locations; and

    f) calculating electrical currents values ($I_i$) for currents flowing in each conductor from said first and second components ($H_x$, $H_y$) of said magnetic field ($\vec{H}$) at each of said number (L) of different locations.

2. The method of claim 1, wherein said one or more magnetic sensors (15, 16, 17, 118, 119, 305, 306, 307, 403, 404) are arranged in a sensor head (11,101), said sensor head having an aperture (12, 102) having a central axis A extending in said third direction z, said sensor head having an inner surface (13, 116, 117) defining a circumference of said aperture, preferably said one or more magnetic sensors are arranged at said number L of different locations at said inner surface, said number L of different locations being larger than said number N of individual conductors.

3. The method of any one of claims 1 or 2, wherein said one or more conductors are arranged in a multi-conductor cable.

4. The method of any one of claims 1 to 3 further comprising the step of

g) displaying said calculated electrical current values ($I_j$), preferably said steps b) to g) are repeated during consecutive measurement cycles.

5. The method of any one of claims 1 to 4, wherein said discrete Fourier transformation in step c) is a Fast Fourier Transformation (FFT), wherein said number (M) of measurements is preferably selected from the group consisting of 128, 256, 512, 1024 and 2048.

6. The method of any one of claims 1 to 5, wherein said sampling frequency (fs) is selected from a range of 200 Hz to 3.2 kHz.

7. The method of any one of claims 1 to 6, wherein said first direction (x) is perpendicular to said third direction (z) and said second direction (y) is perpendicular to said third direction (z) and wherein said step b) further comprises performing said number (M) of measurements at said sampling frequency (fs) of a magnetic field ($\vec{H}$) in said third direction (z).

8. The method of any one of claims 2 to 7, wherein said sensor head (11, 101) further comprises at least one reference magnetic sensor (20,120,121) spaced apart from said inner surface (13, 116, 117) of said aperture (12, 102) of said sensor head (11, 101) and wherein said first and second components ($H_x$, $H_y$) of said magnetic field ($\vec{H}$) are obtained by including corrections ($Href_x$, $Href_y$) obtained from said at least on reference magnetic sensor (20, 120, 121).

9. The method of any one of claims 1 to 8, wherein in step d) said current frequency (fc) is a pre-selected current frequency.

10. The method of any one of claims 4 to 8, wherein in step d) said current frequency (fc) is determined by varying said sampling frequency (fs) in step b) in consecutive measurement cycles and by selecting in step e) the frequency having the largest magnetic field amplitude coefficient as the current frequency (fc).

11. The method of any one of claims 1 to 7, wherein in step e) magnetic field amplitude coefficients which correspond more than one frequency from said frequency distributions of said measurement data are selected and in step f) the root mean square (RMS) of the electrical current ($I_{RMS}$) is calculated.

12. The method of any one of claims 1 to 11, wherein in step b) said number (M) of measurements at said sampling frequency (fs) of said magnetic field ($\vec{H}$) are further performed in said third direction (z) at each of said number (L) of different locations, to obtain said number (M) of measurement data for each of said first, second and third directions (x, y, z).

13. The method of any one of claims 1 to 12, wherein in step f), said electrical currents values ($I_j$) for currents flowing in each conductor are calculated from a trained artificial intelligence model.

14. The method of any one of claims 1 to 12, wherein in step f), said electrical currents values ($I_j$) for currents flowing in each of said *N* conductors are calculated from magnetic field measurements of said number (*L) of* magnetic sensors for the x- and y-components, respectively, arranged at different locations, by numerically solving equations

$$H_{ix} = -\frac{1}{2\pi}\left(\sum_{j=1}^{N} I_j \frac{\Delta y_{ij}}{r_{ij}^2}\right)$$

and

$$H_{iy} = \frac{1}{2\pi}\left(\sum_{j=1}^{N} I_j \frac{\Delta x_{ij}}{r_{ij}^2}\right)$$

for $i = 1$ to $L$, wherein $r_{ij}$ is the distance between magnetic sensor $i$ and conductor $j$ and $\Delta x_{ij}$ and $\Delta y_{ij}$ are the respective x- and y-components of said distance.

15. A device for non-intrusive current measurement in at least one electrical conductor comprising:

a sensor head (11,101) comprising one or more magnetic sensors (15,16,17,118,119) arranged at a number of different locations,
a processing unit (23,126) functionally connected with said magnetic sensors (15,16,17,118,119), said processing unit (23,122,126) being configured to execute steps b) to f) of the method of any one of claims 1 to 14.

16. The device of claim 15, wherein said sensor head comprises an aperture (12, 102) defined by an inner surface (13,116,117) of said sensor head, said aperture having an inner diameter (D) and a central axis (A), and a multiplicity of said magnetic sensors arranged at said number of different locations at said inner surface, preferably said aperture (102) is defined by at least two sections (104,105) of said sensor head (102) which are movable with respect to each other in order to provide an aperture with variable diameter (D).

17. The device of any one of claims 15 or 16, wherein said device is a handheld device (10, 100), preferably said processing unit comprises a micro-circuit (126) arranged in said sensor head (102) and a mobile device (122) removably connectable to said sensor head (102).

18. The device of any one of claims 15 to 17, wherein said device is a stationary device (300).

19. The device any one of claims 15 to 18, wherein said sensor head (311) and said processing unit are remotely connected.

**Patentansprüche**

1. Verfahren zur nicht-intrusiven Strommessung in mindestens einem elektrischen Leiter, das die folgenden Schritte umfasst:

a) Anordnen eines oder mehrerer Magnetfeldsensoren (15, 16, 17, 118, 119, 305, 306, 307, 403, 404) an einer Anzahl (L) verschiedener Stellen neben einer Anzahl (N) einzelner elektrischer Leiter, wobei sich die Leiter in einer dritten Richtung (z) erstrecken;

b) Durchführen einer Anzahl (M) von Messungen mit einer Abtastfrequenz (fs) eines Magnetfeldes ( $\vec{H}$ ) mindestens in einer ersten Richtung (x), die einen ersten Winkel mit der dritten Richtung (z) bildet, und in einer anderen zweiten Richtung (y), die einen zweiten Winkel mit der dritten Richtung (z) bildet, an jeder der Anzahl (L) von verschiedenen Orten, um die Anzahl (M) von Messdaten für jede der ersten und zweiten Richtungen (x, y) zu erhalten;
c) Durchführen einer harmonischen Analyse, vorzugsweise einer diskreten Fourier-Transformation, an jedem Satz der Anzahl (M) von Messdaten für jede der ersten und zweiten Richtungen (x, y), um Frequenzverteilungen der Messdaten zu erhalten;
d) Bestimmen einer Stromfrequenz (fc) der in den Leitern fließenden elektrischen Ströme (I);
e) Auswählen von Magnetfeldamplitudenkoeffizienten, die mindestens der Stromfrequenz (fc) entsprechen, aus den Frequenzverteilungen der Messdaten, um eine erste Komponente (H$_x$) des Magnetfelds ( $\vec{H}$ ) in der ersten Richtung (x) und eine zweite Komponente (H$_y$) des Magnetfelds ( $\vec{H}$ ) in der zweiten Richtung (y) an jedem der Anzahl (L) verschiedener Orte zu erhalten; und
f) Berechnen der Werte der elektrischen Ströme (I$_j$) für die in jedem Leiter fließenden Ströme aus den ersten und zweiten Komponenten (H$_x$, H$_y$) des Magnetfeldes ( $\vec{H}$ ) an jeder der Anzahl (L) der verschiedenen Stellen.

2. Verfahren gemäß Anspruch 1, wobei der eine oder die mehreren Magnetfeldsensoren (15, 16, 17, 118, 119, 305, 306, 307, 403, 404) in einem Sensorkopf (11, 101) angeordnet sind, wobei der Sensorkopf eine Öffnung (12, 102) mit einer zentralen Achse A aufweist, die sich in der dritten Richtung z erstreckt, wobei der Sensorkopf eine innere Oberfläche (13, 116, 117) aufweist, die einen Umfang der Öffnung definiert, wobei vorzugsweise der eine oder die mehreren Magnetfeldsensoren an der Anzahl L verschiedener Stellen an der inneren Oberfläche angeordnet sind, wobei die Anzahl L verschiedener Stellen größer ist als die Anzahl N einzelner Leiter.

3. Verfahren gemäß einem der Ansprüche 1 oder 2, wobei der eine oder die mehreren Leiter in einem Mehrleiterkabel angeordnet sind.

4. Das Verfahren gemäß einem der Ansprüche 1 bis 3 umfasst ferner den Schritt
g) Anzeigen der berechneten elektrischen Stromwerte ($I_j$), wobei die Schritte b) bis g) vorzugsweise während aufeinanderfolgender Messzyklen wiederholt werden.

5. Verfahren gemäß einem der Ansprüche 1 bis 4, wobei die diskrete Fourier-Transformation in Schritt c) eine Fast-Fourier-Transformation (FFT) ist, wobei die Anzahl (M) der Messungen vorzugsweise aus der Gruppe bestehend aus 128, 256, 512, 1024 und 2048 ausgewählt ist.

6. Verfahren gemäß einem der Ansprüche 1 bis 5, wobei die Abtastfrequenz (fs) aus einem Bereich von 200 Hz bis 3,2 kHz ausgewählt wird.

7. Verfahren gemäß einem der Ansprüche 1 bis 6, wobei die erste Richtung (x) senkrecht zu der dritten Richtung (z) und die zweite Richtung (y) senkrecht zu der dritten Richtung (z) ist und wobei der Schritt b) ferner die Durchführung der Anzahl (M) von Messungen eines Magnetfeldes ($\vec{H}$) in der dritten Richtung (z) bei der Abtastfrequenz (fs) umfasst.

8. Verfahren gemäß einem der Ansprüche 2 bis 7, wobei der Sensorkopf (11, 101) ferner mindestens einen ReferenzMagnetfeldsensor (20, 120, 121) aufweist, der von der Innenfläche (13, 116, 117) der Öffnung (12, 102) des Sensorkopfes (11, 101) beabstandet ist, und wobei die ersten und zweiten Komponenten ($H_x$, $H_y$) des Magnetfeldes ($\vec{H}$) durch Einbeziehen von Korrekturen ($Href_x$, $Href_y$) erhalten werden, die von dem mindestens einen Referenz-Magnetfeldsensor (20, 120, 121) erhalten werden.

9. Verfahren gemäß einem der Ansprüche 1 bis 8, wobei in Schritt d) die Stromfrequenz (fc) eine vorgewählte Stromfrequenz ist.

10. Verfahren gemäß einem der Ansprüche 4 bis 8, wobei in Schritt d) die Stromfrequenz (fc) bestimmt wird, indem die Abtastfrequenz (fs) in Schritt b) in aufeinanderfolgenden Messzyklen variiert wird und indem in Schritt e) die Frequenz mit dem größten Magnetfeldamplitudenkoeffizienten als Stromfrequenz (fc) ausgewählt wird.

11. Verfahren gemäß einem der Ansprüche 1 bis 7, wobei in Schritt e) Magnetfeldamplitudenkoeffizienten, die mehr als einer Frequenz aus den Frequenzverteilungen der Messdaten entsprechen, ausgewählt werden und in Schritt f) der quadratische Mittelwert (RMS) des elektrischen Stroms ($I_{RMS}$) berechnet wird.

12. Verfahren gemäß einem der Ansprüche 1 bis 11, wobei in Schritt b) die Anzahl (M) von Messungen bei der Abtastfrequenz (fs) des Magnetfeldes ($\vec{H}$) außerdem in der dritten Richtung (z) an jeder der Anzahl (L) von verschiedenen Stellen durchgeführt wird, um die Anzahl (M) von Messdaten für jede der ersten, zweiten und dritten Richtungen (x, y, *z*) zu erhalten.

13. Verfahren gemäß einem der Ansprüche 1 bis 12, wobei in Schritt f) die elektrischen Stromwerte ($I_j$) für in jedem Leiter fließende Ströme anhand eines trainierten Modells einer künstlichen Intelligenz berechnet werden.

14. Verfahren gemäß einem der Ansprüche 1 bis 12, wobei in Schritt f) die elektrischen Stromwerte ($I_j$) für Ströme, die in jedem der *N* Leiter fließen, aus Magnetfeldmessungen der Anzahl (*L*) von Magnetfeldsensoren für die x- bzw. y-Komponenten, die an verschiedenen Stellen angeordnet sind, durch numerisches Lösen der Gleichungen berechnet werden

$$H_{ix} = -\frac{1}{2\pi}\left(\sum_{j=1}^{N} I_j \frac{\Delta y_{ij}}{r_{ij}{}^2}\right)$$

und

$$H_{iy} = \frac{1}{2\pi}\left(\sum_{j=1}^{N} I_j \frac{\Delta x_{ij}}{r_{ij}^2}\right)$$

für *i= 1 bis L,* wobei *$r_{ij}$* der Abstand zwischen dem Magnetfeldsensor *i* und dem Leiter *j* ist und *$\Delta x_{ij}$* und *$\Delta y_{ij}$* die jeweiligen x- und y-Komponenten dieses Abstandes sind.

**15.** Vorrichtung zur nicht-invasiven Strommessung in mindestens einem elektrischen Leiter, umfassend:

einen Sensorkopf (11, 101), der einen oder mehrere Magnetfeldsensoren (15, 16, 17, 118, 119) umfasst, die an einer Reihe von verschiedenen Stellen angeordnet sind,
eine Verarbeitungseinheit (23, 126), die funktional mit den Magnetfeldsensoren (15, 16, 17, 118, 119) verbunden ist, wobei die Verarbeitungseinheit (23, 122, 126) so konfiguriert ist, dass sie die Schritte b) bis f) des Verfahrens gemäß einem der Ansprüche 1 bis 14 ausführt.

**16.** Vorrichtung nach Anspruch 15, wobei der Sensorkopf eine Öffnung (12, 102) umfasst, die durch eine innere Oberfläche (13, 116, 117) des Sensorkopfes definiert ist, wobei die Öffnung einen inneren Durchmesser (D) und eine zentrale Achse (A) aufweist, und eine Vielzahl der Magnetfeldsensoren, die an der Anzahl von verschiedenen Stellen an der inneren Oberfläche angeordnet sind, wobei die Öffnung (102) vorzugsweise durch mindestens zwei Abschnitte (104, 105) des Sensorkopfes (102) definiert ist, die in Bezug zueinander beweglich sind, um eine Öffnung mit variablem Durchmesser (D) bereitzustellen.

**17.** Vorrichtung nach einem der Ansprüche 15 oder 16, wobei es sich bei der Vorrichtung um ein tragbares Gerät (10, 100) handelt, wobei die Verarbeitungseinheit vorzugsweise eine in dem Sensorkopf (102) angeordnete Mikroschaltung (126) und eine mit dem Sensorkopf (102) lösbar verbindbare mobile Vorrichtung (122) umfasst.

**18.** Die Vorrichtung nach einem der Ansprüche 15 bis 17, wobei die Vorrichtung eine stationäre Vorrichtung (300) ist.

**19.** Vorrichtung nach einem der Ansprüche 15 bis 18, wobei der Sensorkopf (311) und die Verarbeitungseinheit ferngesteuert sind.

**Revendications**

**1.** Procédé de mesure non intrusive de courant dans au moins un conducteur électrique, comprenant les étapes de :

a) agencer un ou plusieurs capteurs magnétiques (15, 16, 17, 118, 119, 305, 306, 307, 403, 404) à un nombre (L) d'emplacements différents adjacents à un nombre (N) de conducteurs électriques individuels, lesdits conducteurs s'étendant dans une troisième direction (z) ;
b) effectuer un nombre (M) de mesures à une fréquence d'échantillonnage (fs) d'un champ magnétique (H) au moins dans une première direction (x) formant un premier angle avec ladite troisième direction (z) et dans une deuxième direction (y) différente formant un deuxième angle avec ladite troisième direction (z), à chacun desdits nombres (L) d'emplacements différents, pour obtenir ledit nombre (M) de données de mesure pour chacune desdites première et deuxième directions (x, y) ;
c) effectuer une analyse d'harmoniques, de préférence une transformation de Fourier discrète, sur chaque ensemble dudit nombre (M) de données de mesure pour chacune desdites première et deuxième directions (x, y) pour obtenir des distributions de fréquence desdites données de mesure ;
d) déterminer une fréquence de courant (fc) de courants électriques (1) passant dans lesdits conducteurs;
e) sélectionner des coefficients d'amplitude de champ magnétique qui correspondent au moins à ladite fréquence de courant (fc) desdites distributions de fréquence desdites données de mesure pour obtenir une première composante ($H_x$) dudit champ magnétique (H) dans ladite première direction (x) et une deuxième composante ($H_y$) dudit champ magnétique (H) dans ladite deuxième direction (y) à chacun desdits nombres (L) d'emplacements différents ; et
f) calculer des valeurs de courants électriques ($I_i$) pour les courants passant dans chaque conducteur desdites première et deuxième composantes ($H_x$, $H_y$) dudit champ magnétique (H) à chacun desdits nombres (L) d'emplacements différents.

2. Procédé selon la revendication 1, lesdits un ou plusieurs capteurs magnétiques (15, 16, 17, 118, 119, 305, 306, 307, 403, 404) sont disposés dans une tête de capteur (11,101), ladite tête de capteur ayant une ouverture (12, 102) avec un axe central A s'étendant dans ladite troisième direction z, ladite tête de capteur ayant une surface intérieure (13, 116, 117) définissant une circonférence de ladite ouverture, de préférence, lesdits un ou plusieurs capteurs magnétiques sont disposés audit nombre L d'emplacements différents sur ladite surface intérieure, ledit nombre L d'emplacements différents étant supérieur audit nombre N de conducteurs individuels.

3. Procédé selon l'une des revendications 1 ou 2, ledit un ou plusieurs conducteurs étant disposés dans un câble multiconducteur.

4. Procédé selon l'une des revendications 1 à 3, comprenant en outre l'étape
g) d'afficher lesdites valeurs calculées de courant électrique ($I_j$), de préférence, lesdites étapes b) à g) étant répétées pendant des cycles de mesure consécutifs.

5. Procédé selon l'une des revendications 1 à 4, dans lequel ladite transformation de Fourier discrète à l'étape c) est une transformation de Fourier rapide (FFT), ledit nombre (M) de mesures étant choisi de préférence du groupe consistant de 128, 256, 512, 1024 et 2048.

6. Procédé selon l'une des revendications 1 à 5, ladite fréquence d'échantillonnage (fs) étant choisie dans une plage de 200 Hz à 3,2 kHz.

7. Procédé selon l'une des revendications 1 à 6, ladite première direction (x) étant perpendiculaire à ladite troisième direction (z) et ladite deuxième direction (y) étant perpendiculaire à ladite troisième direction (z) et ladite étape b) comprenant en outre la réalisation dudit nombre (M) de mesures à ladite fréquence d'échantillonnage (fs) d'un champ magnétique (H) dans ladite troisième direction (z).

8. Procédé selon l'une des revendications 2 à 7, ladite tête de capteur (11, 101) comprenant en outre au moins un capteur magnétique de référence (20, 120, 121) espacé de ladite surface intérieure (13, 116, 117) de ladite ouverture (12, 102) de ladite tête de capteur (11, 101) et lesdites première et deuxième composantes ($H_x$, $H_y$) dudit champ magnétique *(H)* étant obtenues en incluant des corrections ($Href_x$, $Href_y$) obtenues par ledit au moins un capteur magnétique de référence (20, 120, 121).

9. Procédé selon l'une des revendications 1 à 8, à l'étape d), ladite fréquence de courant (fc) étant une fréquence de courant présélectionnée.

10. Procédé selon l'une des revendications 4 à 8, à l'étape d), ladite fréquence de courant (fc) étant déterminée en faisant varier ladite fréquence d'échantillonnage (fs) à l'étape b) lors de cycles de mesure consécutives et en choisissant à l'étape e) comme fréquence de courant (fc) la fréquence ayant le plus grand coefficient d'amplitude de champ magnétique.

11. Procédé selon l'une des revendications 1 à 7, à l'étape e), les coefficients d'amplitude de champ magnétique qui correspondent à plus d'une fréquence desdites distributions de fréquence desdites données de mesure étant choisis et à l'étape f) la racine moyenne quadratique (RMS) du courant électrique ($I_{RMS}$) étant calculée.

12. Procédé selon l'une des revendications 1 à 11, à l'étape b), ledit nombre (M) de mesures à ladite fréquence d'échantillonnage (fs) dudit champ magnétique (H) étant en outre effectuées dans ladite troisième direction (z) à chacun dudit nombre (L) d'emplacements différents pour obtenir ledit nombre (M) de données de mesure pour chacune desdites première, deuxième et troisième directions (x, y, z).

13. Procédé selon l'une des revendications 1 à 12, à l'étape f), lesdites valeurs de courants électriques ($I_j$) pour les courants passant dans chaque conducteur étant calculées à partir d'un modèle d'intelligence artificielle entraîné.

14. Procédé selon l'une des revendications 1 à 12, à l'étape f), lesdites valeurs de courants électriques ($I_j$) pour les courants passant dans chacun desdits N conducteurs étant calculées à partir de mesures de champ magnétique dudit nombre (L) de capteurs magnétiques pour les composantes x et y, respectivement disposés à des emplacements différents, en résolvant numériquement des équations

$$H_{ix} = -\frac{1}{2\pi}\left(\sum_{j=1}^{N} I_j \frac{\Delta y_{ij}}{r_{ij}{}^2}\right)$$

et

$$H_{iy} = \frac{1}{2\pi}\left(\sum_{j=1}^{N} I_j \frac{\Delta x_{ij}}{r_{ij}{}^2}\right)$$

pour $i= 1$ à $L$, $r_{ij}$ étant la distance entre le capteur magnétique $i$ et le conducteur $j$ et $\Delta x_{ij}$ et $\Delta y_{ij}$ étant les composantes x et y respectives de ladite distance.

15. Dispositif de mesure non intrusive de courant dans au moins un conducteur électrique, comprenant :

une tête de capteur (11, 101) comprenant un ou plusieurs capteurs magnétiques (15, 16, 17, 118, 119) agencés à un nombre d'emplacements différents,
une unité de traitement (23, 126) fonctionnellement connectée auxdits capteurs magnétiques (15, 16, 17, 118, 119), ladite unité de traitement (23, 122, 126) étant configurée pour réaliser les étapes b) à f) du procédé selon l'une des revendications 1 à 14.

16. Dispositif selon la revendication 15, ladite tête de capteur comprenant une ouverture (12, 102) définie par une surface intérieure (13, 116, 117) de ladite tête de capteur, ladite ouverture ayant un diamètre intérieur (D) et un axe central (A), et une multitude desdits capteurs magnétiques disposés audit nombre d'emplacements différents sur ladite surface intérieure, de préférence ladite ouverture (102) étant définie par au moins deux sections (104,105) de ladite tête de capteur (102) qui sont mobiles l'un par rapport à l'autre afin de fournir une ouverture à diamètre variable (D).

17. Dispositif selon l'une des revendications 15 ou 16, ledit dispositif étant un dispositif portable (10, 100), de préférence, ladite unité de traitement comprenant un microcircuit (126) disposé dans ladite tête de capteur (102) et un dispositif mobile (122) connectable de manière amovible à ladite tête de capteur (102).

18. Dispositif selon l'une des revendications 15 à 17, ledit dispositif étant un dispositif stationnaire (300).

19. Dispositif selon l'une des revendications 15 à 18, ladite tête de capteur (311) et ladite unité de traitement étant connectées à distance.

*Fig. 1*

**Fig. 2**

**Fig. 3**

**Fig. 4**

**EP 4 469 810 B1**

**Patent documents cited in the description**

- US 20120319676 A1
- WO 2015144541 A2
- WO 2013068360 A1